# EUROPEAN PATENT SPECIFICATION

(11) **EP 1 760 038 B1**
(45) Date of publication and mention of the grant of the patent: **26.06.2013**
(21) Application number: 06119036.9
(22) Date of filing: 16.08.2006
(51) Int. Cl.: B81C 1/00

(54) **Method for manufacturing a mass-spring system**
Verfahren zum Herstellen eines Masse-Feder Systems
Procédé de fabrication d'un système à masse suspendue sur ressort

(30) Priority: 06.09.2005 EP 05255430
(43) Date of publication of application: 07.03.2007
(73) Proprietor: Infineon Technologies AG, 85579 Neubiberg (DE)
(72) Inventor: Jakobsen, Henrik, N-3192, Horten (NO)
(74) Representative: Stöckeler, Ferdinand

(56) References cited:
- EP-A- 0 343 784
- WO-A-2004/083111
- US-A- 4 342 227
- US-A- 5 242 533
- US-A1- 2002 020 053
- US-A1- 2002 135 033

## Description

The present invention relates to the manufacture of a micromechanical mass-spring system for use as an inertial device. The invention further relates to micromechanical mass-spring systems incorporating thin asymmetric springs and a method of manufacturing such systems, using bulk etching and bulk and/or surface micromachining techniques.

Micro electromechanical systems (MEMS) are becoming increasingly important in the manufacture of inertial devices such as angular rate sensors and multiple axis accelerometers. Micromechanical structures such as asymmetric springs, diaphragms and mass-spring systems are increasingly used in such devices, where these structures are used to obtain in-plane movements of structures when applying out-of-plane forces. The manufacturing methods of these structures generally involve bulk micromachining techniques.

Known devices which use such methods are realised by using the full wafer thickness of (100) silicon to define, for example, an asymmetric spring along the (111) plane by etching from both sides of the wafer. This results in springs typically thicker than 30 microns and a large spread in thickness, and a resulting large chip size. These methods strongly limit the downscaling of the dimensions of such springs, thereby limiting improvements in chip size and manufacturing costs.

Further prior art methods for manufacturing the asymmetric springs have aimed to reduce chip size using a combination of etch-stop against pn-junction techniques to form the thickness of the springs, a shallow wet etch to form the asymmetric feature and dry etching to release the springs from the manufacturing substrate. Such methods can produce springs with a practical thickness in the range of 10 to 20 microns, and a reduced width of approximately 5 microns including an asymmetric cut.

Known devices which employ such methods include devices for measuring force components using monocrystalline materials, such as 2-axis and 3-axis accelerometers and devices for measuring angular velocity and angular rate.

As mentioned above, limitations currently exist in the manufacturing methods of micromechanical structures such as asymmetric springs, and there is a need within the related industry to produce thinner structures in order to reduce the chip size of micromechanical inertial devices, in a cost-effective manner.

The present invention seeks to overcome the aforementioned problems, by providing an alternative manufacturing method which can be used to build mass-spring systems comprising asymmetric springs with a thickness down to sub-micron values and a corresponding width in the range of 1 micron or more, in an efficient and effective manufacturing method.

US-B-4342227 discloses a planar semiconductor three direction acceleration detecting device and method of fabrication; EP-A-0343784 discloses a method for manufacturing a silicon force transducer; and WO 2004/083111 discloses a method for manufacturing a membrane in a surface of a silicium wafer.

According to the present invention there is provided a method for manufacturing a micromechanical mass-spring system comprising a mass and a spring, according to claim 1.

Implementation of the present invention by using silicon process technology and by using photolithographic methods, thin-film deposition, doping and etching processes leads to the manufacture of much thinner asymmetric springs within mass-spring systems, thereby providing greater flexibility in the manufacture of inertial devices in which in-plane movements of micromechanical structures such as asymmetric springs occur when applying out-of-plane forces to the structures.

Mass-spring systems manufactured according to the present invention may also be incorporated in applications such as: 2- and 3-axis accelerometers, which may include capacitive detection; 1- and 2-axis angular rate sensors with electrostatic excitation and capacitive detection; a capacitive inertial measurement unit (IMU) comprising two chips, one of which has a gyro having up to two axes and an accelerometer having up to three axes, and the other of which has three signal conditioning means; and a complete single-chip IMU with a gyro having up to two axes and an accelerometer having up to three axes on the same chip.

A reduced chip size allows multiple inertial devices to be placed on the same chip, thereby facilitating the fitting of the chip to, for example, a vehicle.

Such devices may also be employed to design and manufacture different types of actuators that take advantage of obtaining in-plane movements when applying out of plane forces; for example parts for microvalves, micropumps, microgrippers, microhandling, microbiotics, etc.

Examples of the present invention will now be described with reference to the accompanying drawings, in which:

Figure 2 shows an example of the manufacture of a mass-spring system according to the present invention in which some of the techniques of the method of figure 1 are employed;
Figure 3 shows the manufacturing steps for creating out-of-plane springs in poly-silicon or other thin-film material;
Figure 4 shows an example of the manufacture of a mass-spring system according to the present invention in which some of the techniques of the method of figure 2 are employed;
Figure 5 shows a further example of the manufacture of a mass-spring system according to the present invention in which some of the techniques of the method of figure 2 are employed; and
Figure 6 shows an example of a combined 3-axis accelerometer and 2-axis angular rate sensor, which incorporate mass-spring systems according to the present invention, on one chip.

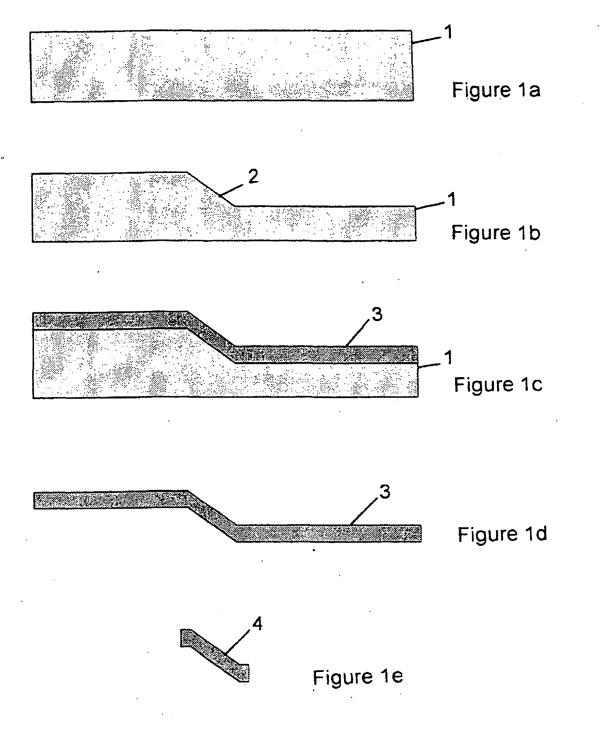

Referring to figure 1, the first step for manufacturing asymmetric springs in single crystal silicon according to one example of the invention is to provide a silicon substrate 1 on which the springs can be formed. In this example, the use of p-type silicon in the (100) plane is described, however other silicon substrates can be used. A single crystal or silicon on insulator substrate may be employed.

Next, an anisotropic etching technique is used to etch the section of the silicon substrate 1 in the (111) plane, defining a wall 2 along this plane as illustrated in figure 1b.

Figure 1c illustrates the formation of a doped surface layer 3 on the substrate 1. The n-type surface layer 3 is built by ion implantation and diffusion, and lies across the (111) wall 2 etched on the silicon substrate 1. The surface layer 3 is then detached from the substrate 1 (figure 1d) using an etch-stop against pn-junction technique in order to form of an asymmetric spring 4 with a desired the asymmetric feature and thickness.

Finally, it is necessary to release the asymmetric spring 4 from the remainder of the surface layer 3 (figure 1e). This is done by standard photolithographic methods and dry-etching such as reactive ion etching (RIE), to create the length and width of the spring 4, which is shaped by the (111) silicon substrate wall 2 which acts as a support frame. This produces an asymmetric spring 4 with a thickness in the sub-micron to micron range, and a width in the range of one micron and above.

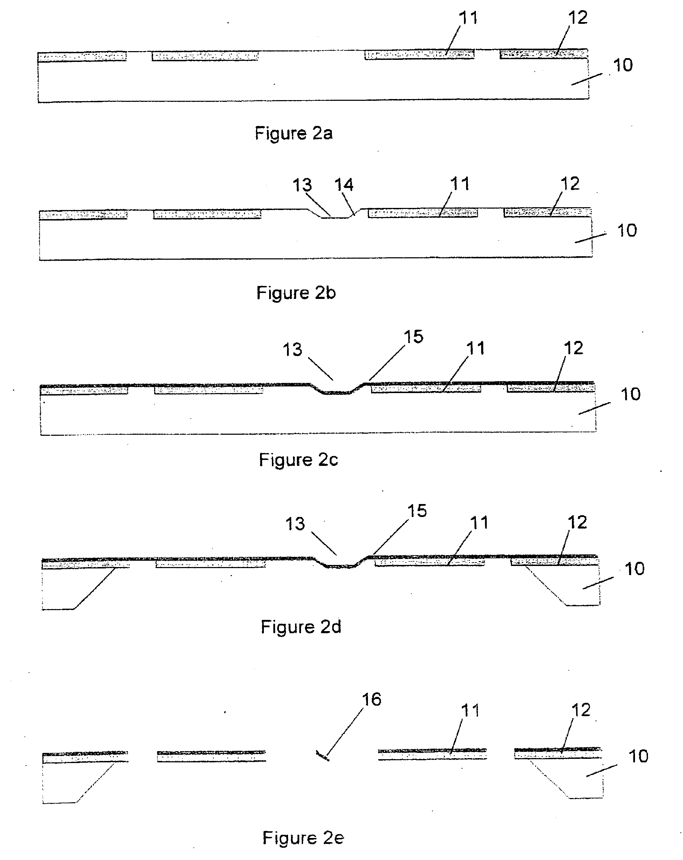

Figure 2 shows a method of manufacturing a mass-spring system with a thin asymmetric spring according to the present invention. The method incorporates a method of manufacturing an asymmetric spring similar to that exemplified above in relation to figure 1. A substrate in the form of a p-type (100) silicon wafer 10 is doped with an n-type dopant to form masses 11 and a frame 12 of the mass-spring system, as shown in figure 2a. Anisotropic etching is performed (figure 2b) to form one or more grooves 13 with side walls 14 etched at a desired angle, for example in the (111) silicon plane. Figure 2c illustrates the formation of a shallow doped surface layer 15 on the wafer 10. The n-type surface layer 15 is built by ion implantation and diffusion, and lies across the surfaces of the silicon wafer 10 including those of the groove 13 etched on the silicon wafer 10. The thickness of surface layer 15 determines the thickness of an asymmetric spring to be formed. Figure 2d shows the result of electrochemical selective etching from a rear side of the wafer that stops against the pn-junction created. Finally, a complete mass-spring system is released from a front side of the wafer by, for example, dry etching (figure 2e) to complete the manufacture of the mass-spring system including an asymmetric spring 16.

The above method uses a combination of anisotropic wet etching, doping by ion implantation, etch-stop against pn-junction and dry etching techniques to create thin asymmetric springs in single-crystal silicon. The bulk micromachining techniques described can be combined with other processes to build complete sensor chips and other micromechanical inertial devices according to the present invention.

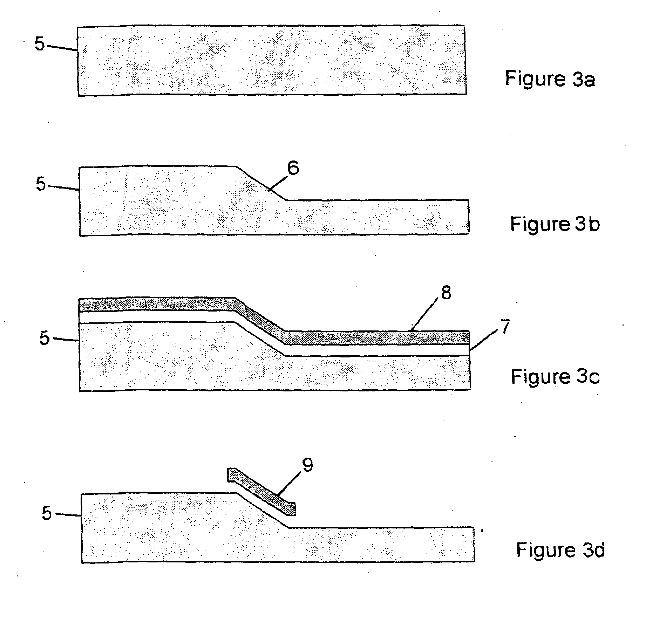

A further example of a manufacturing method of an asymmetric spring is illustrated in figure 3. This sequence of steps can be used to create out-of-plane asymmetric springs in poly-silicon or other deposited thin-film materials. Again, a p-type silicon substrate 5 in the (100) plane is provided on which to base the formation of the asymmetric springs. Anisotropic etching is performed to define a wall 6 along the (111) plane of the substrate 5 (figure 3b).

Next, a sacrificial layer 7 is created above the etched silicon substrate 5, as shown in figure 3c. The sacrificial layer 7 can be formed by thermal oxidation, or by depositing, for example, silicon dioxide onto the substrate 5. The sacrificial layer 7 can be composed of thermally grown silicon dioxide, deposited doped or undoped silicon dioxide, or other thin-film material that can be selectively removed and that can withstand the deposition temperature of the surface layer. A layer of elastic thin-film material, for example, poly-silicon 8, from which an asymmetric spring 9 will eventually be formed, is then deposited on the sacrificial layer 7 (figure 3c).

Finally, the poly-silicon layer 8 and sacrificial layer 7 are etched to form the asymmetric spring 9 and to release the micromechanical structure from the substrate 5, as shown in figure 3d.

The above steps therefore use a combination of bulk etching and surface-micromachining to create micromechanical structures such as thin asymmetric springs. This example of the present invention can be extended to build two-axis angular rate sensors and three-axis accelerometers as full single-chip structures.

The above methods are not limited to the realisation of springs along the (111) plane on (100) substrate, out-of-plane springs can also be manufactured by etchings at different angles to the substrate surface plane. For example, different angles can be created on the substrate by using isotropic etching and deep, near 90° vertical etching. According to the present invention, micromechanical structures such as mass-spring systems for inertial devices can be made with a large variety of geometries, as defined by desigining the patterns on photolithographic masks to be used in the photolithographic process that are incorporated in the manufacture of such asymmetric springs, as described below.

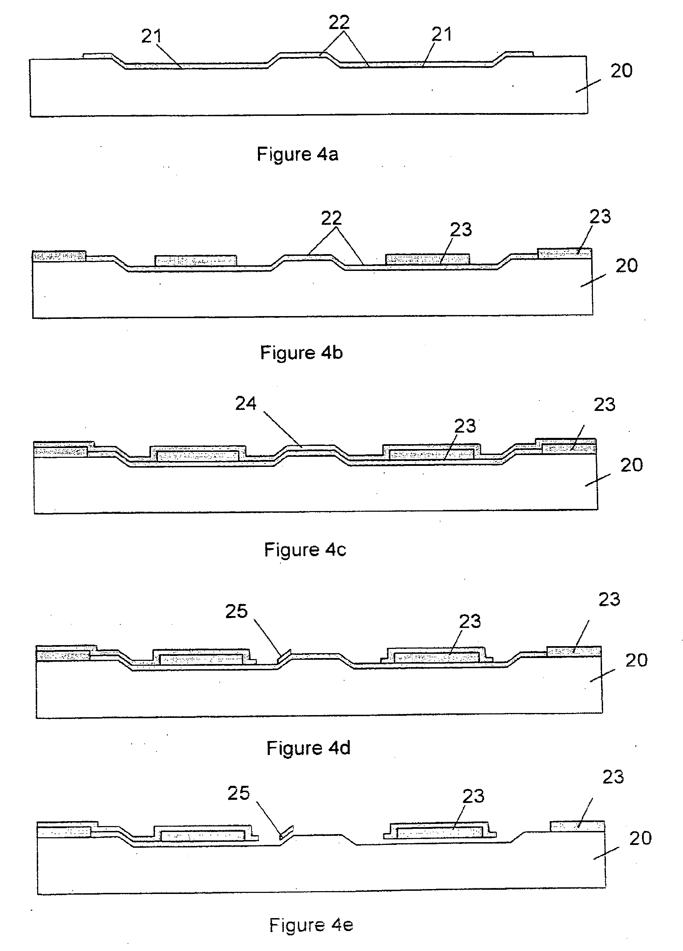

Figure 4 shows a further method of manufacturing a mass-spring system with a thin asymmetric spring according to the present invention. The method incorporates a method of manufacturing an asymmetric spring similar to that exemplified above in relation to figure 2. One or more recesses 21 are etched in a silicon substrate 20 and a sacrificial layer 22 is deposited and etched therein as shown in figure 4a. Masses 23 are deposited on the sacrificial layer 22 and/or substrate 20 and are etched as required (figure 4b). A spring material layer 24 of, for example, poly-silicon, is then deposited on the sacrificial layer 22 and/or masses 23 (figure 4c), and this spring material layer 24 is then etched to form a spring 25 of the mass-spring system (figure 4d). Finally, the mass-spring system is released by etching of the sacrificial layer 22 (figure 4e).

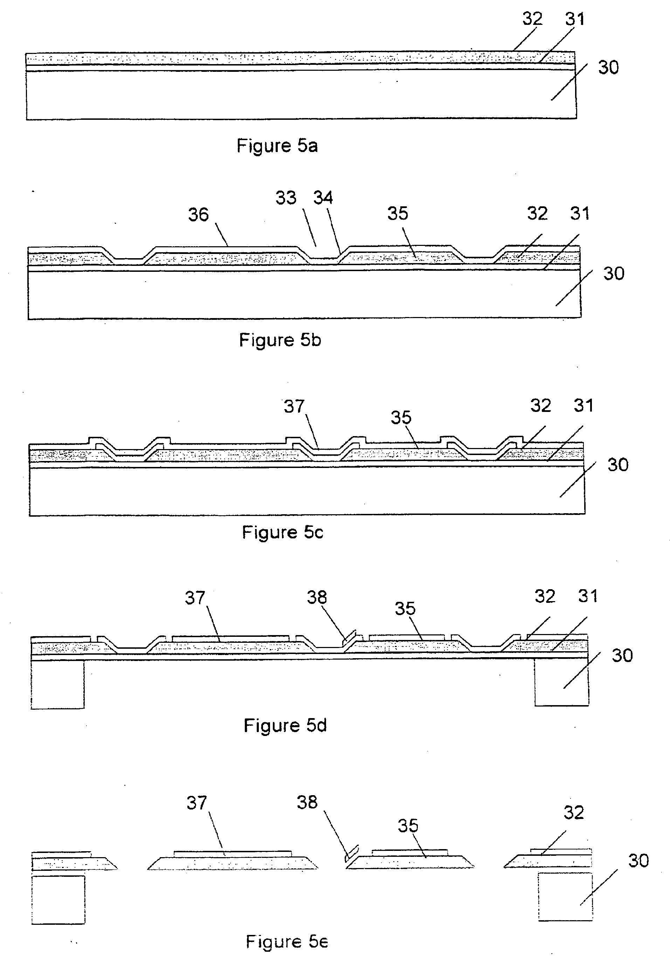

Figure 5 shows a further method of manufacturing a mass-spring system with a thin asymmetric spring according to the present invention. This method also incorporates a method of manufacturing an asymmetric spring similar to that exemplified above in relation to figure 2. In this example, a silicon-on-insulator (SOl) wafer in the (100) plane comprising a silicon substrate 30, an insulating layer 31 and a p-type surface layer 32, is provided (figure 5a). One or more grooves 33 are provided by anisotropic etching of the substrate. The angles of the side walls 34 of the grooves can be in the (111) planes. The grooves define masses 35 in the substrate and provide areas on which springs are to be manufactured. A sacrificial layer 36 is then deposited over the substrate and masses (figure 5b) and etched (figure 5c). Thin-film spring material 37, such as poly-silicon, is then deposited on the sacrificial layer 36 (figure 5c) and this is then etched to define the geometry of a spring 37 (figure 5d). In this example, deep reactive ion etching is used to etch a rear side of the silicon wafer 30,31, such etching stopping against the insulating layer 32 (figure 5e). Finally, the insulating layer 32 is etched in an appropriate manner and the sacrificial layer 36 is removed to provide the mass-spring system comprising the thin asymmetric spring 38 (figure 5f).

As alternatives to performing anisotropic etching initially on the substrate, wet isotropic etching can be used, resulting in curved elements, or dry RIE etching can be used to define other angles between the surface plane of the substrate and masses and the surface plane of the spring elements.

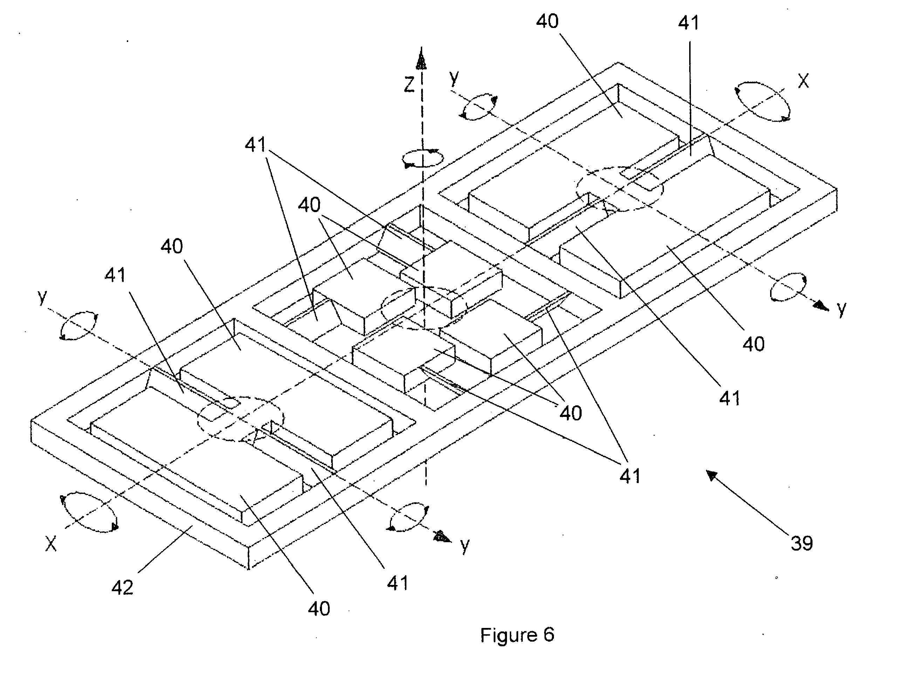

Figure 6 shows an example of the implementation of the present invention to provide a combined 3-axis accelerometer and 2-axis angular rate sensor on a single inertial measurement unit (IMU) chip 39. in this example, masses 40 and springs 41 are provided on a single frame 42. Mass-spring systems according to the present invention can be provided in various combinations depending on the requirements of a user, and the integration of such systems on a single chip allows smaller, more reliable devices to be manufactured.

Alternative thin-film materials to poly-silicon may be used in the present invention, including strong elastic dielectrics such as silicon-nitride, other semiconductor materials such as poly silicon germanium or silicon carbon, silicon-carbide, diamond-like-carbon and different metal films or insulating films which perform well as spring material, elastic thin-film materials such as Mo, W, Ti and Ni, and alloys including the shape-memory alloy TiNi.

The present invention therefore provides an efficient method of producing micromechanical mass-spring systems comprising asymmetric springs which are a great deal thinner than those obtained by previous known methods. This allows for smaller, more compact and less expensive mircromechanical devices to be built with masses and asymmetric springs as required to obtain in-plane movements when applying out-of-plane forces, such as angular rate sensors and multiple axis accelerometers.

## Claims

1. A method for manufacturing a micromechanical mass-spring system comprising a mass (23) and a spring (25), the method comprising the steps of :
providing a silicon substrate (20), wherein the silicon substrate is in the [100] plane;
forming a mass (11, 23, 41) on the substrate; **characterised in that** the method further comprises the steps of
anisotropic or wet isotropic or dry RIE etching the silicon substrate (20), at a desired angle relative to the [100] plane, to define a slanted section (2, 6, 14) upon which the spring (25) is to be formed;
forming a surface layer (3, 8, 15), having a thickness determining the thickness of a spring to be formed on the surface of the substrate;
etching to form a spring (4, 16, 9, 25, 41) from the surface layer; and
dry etching to release the mass and spring from the substrate.

2. A method for manufacturing a micromechanical mass-spring system according to claim 1, wherein the silicon substrate is anisotropically etched to define the slanted section parallel to the [111] plane.

3. A method for manufacturing a micromechanical mass-spring system according to claims 1 or 2, the method further comprising the step of:
doping the surface of the substrate via ion implantation or surface based deposition, such that opposite doping occurs, in order to form the surface layer.

4. A method for manufacturing a micromechanical mass-spring system according to claim 3, the method further comprising the step of:
performing an etch-stop against pn-junction technique to form an asymmetrical shape of the asymmetric spring.

5. A method for manufacturing a micromechanical mass-spring system according to any preceding claim, wherein the surface layer is formed of single-crystal silicon.

6. A method for manufacturing a micromechanical mass-spring system according to any of claims 1 to 3, further comprising the step of;
forming a sacrificial layer between the silicon substrate and the surface layer via thermal oxidation.

7. A method for manufacturing a micromechanical mass-spring system according to any of claims 1 to 3, further comprising the step of;
forming a sacrificial layer via deposition of a material on the silicon substrate.

8. A method for manufacturing a micromechanical mass-spring system according to claim 6 or 7, wherein the surface layer is formed of one of poly silicon, SiC, Ti, Ni or TiNi.

9. A mass-spring system manufactured according to the method of the preceding claims.

10. A 2- or 3-axis accelerometer comprising a mass-spring system according to claim 9.

11. An angular rate sensor comprising a mass-spring system according to claim 9.

12. An inertial measurement unit (IMU) comprising one or more mass-spring systems according to claim 9.

13. An inertial measurement unit (IMU) according to claim 12, the IMU comprising a chip, the chip further comprising a 2-axis gyro and a 3-axis accelerometer.

14. An inertial measurement unit (IMU) according to claim 13, the IMU further comprising a second chip having signal conditioning means.

## Patentansprüche

1. Verfahren zum Herstellen eines mikromechanischen Masse-Feder-Systems, das eine Masse (23) und eine Feder (25) umfasst, wobei das Verfahren die folgenden Schritte umfasst:
Bereitstellen eines Siliziumsubstrats (20), wobei sich das Siliziumsubstrat in der [100]-Ebene befindet;
Bilden einer Masse (11, 23, 41) auf dem Substrat;
**dadurch gekennzeichnet, dass** das Verfahren ferner die folgenden Schritte umfasst:
anisotropes oder nassisotropes oder trockenes RIE-Ätzen des Siliziumsubstrats (20) unter einem Sollwinkel relativ zu der [100]-Ebene, um einen schrägen Abschnitt (2, 6, 14) zu definieren, auf dem die Feder (25) gebildet werden soll;
Bilden einer Oberflächenschicht (3, 8, 15), die eine Dicke aufweist, die die Dicke einer Feder, die auf der Oberfläche des Substrats gebildet werden soll, bestimmt;
Ätzen, um aus der Oberflächenschicht eine Feder (4, 16, 9, 25, 41) zu bilden; und
Trockenätzen, um die Masse und die Feder von dem Substrat zu lösen.

2. Verfahren zum Herstellen eines mikromechanischen Masse-Feder-Systems nach Anspruch 1, wobei das Siliziumsubstrat anisotrop geätzt wird, um den schrägen Abschnitt parallel zu der [111]-Ebene zu definieren.

3. Verfahren zum Herstellen eines mikromechanischen Masse-Feder-Systems nach den Ansprüchen 1 oder 2, wobei das Verfahren ferner den folgenden Schritt umfasst:
Dotieren der Oberfläche des Substrats über Ionenimplantation oder oberflächenbasierte Abscheidung, so dass entgegengesetzte Dotierung entsteht, um die Oberflächenschicht zu bilden.

4. Verfahren zum Herstellen eines mikromechanischen Masse-Feder-Systems nach Anspruch 3, wobei das Verfahren ferner den folgenden Schritt umfasst:
Ausführen einer Technik eines Ätzstopps gegen pn-Übergang, um eine asymmetrische Form der asymmetrischen Feder zu bilden.

5. Verfahren zum Herstellen eines mikromechanischen Masse-Feder-Systems nach einem der vorhergehenden Ansprüche, wobei die Oberflächenschicht aus einkristallinem Silizium gebildet ist.

6. Verfahren zum Herstellen eines mikromechanischen Masse-Feder-Systems nach einem der Ansprüche 1 bis 3, das ferner den folgenden Schritt umfasst:
Bilden einer Opferschicht zwischen dem Siliziumsubstrat und der Oberflächenschicht durch thermische Oxidation.

7. Verfahren zum Herstellen eines mikromechanischen Masse-Feder-Systems nach einem der Ansprüche 1 bis 3, das ferner den folgenden Schritt umfasst:
Bilden einer Opferschicht durch Aufbringen eines Materials auf das Siliziumsubstrat.

8. Verfahren zum Herstellen eines mikromechanischen Masse-Feder-Systems nach Anspruch 6 oder 7, wobei die Oberflächenschicht aus Polysilizium, SiC, Ti, Ni oder TiNi gebildet ist.

9. Masse-Feder-System, das gemäß dem Verfahren der vorhergehenden Ansprüche hergestellt ist.

10. 2- oder 3-achsiger Beschleunigungsmesser, der ein Masse-Feder-System nach Anspruch 9 umfasst.

11. Winkelgeschwindigkeitssensor, der ein Masse-Feder-System nach Anspruch 9 umfasst.

12. Trägheitsmesseinheit (IMU), die ein oder mehrere Masse-Feder-Systeme nach Anspruch 9 umfasst.

13. Trägheitsmesseinheit (IMU) nach Anspruch 12, wobei die IMU einen Chip umfasst und der Chip ferner ein 2-achsiges Gyrometer und einen 3-achsigen Beschleunigungsmesser umfasst.

14. Trägheitsmesseinheit (IMU) nach Anspruch 13, wobei die IMU ferner einen zweiten Chip umfasst, der Signalaufbereitungsmittel umfasst.

## Revendications

1. Procédé de fabrication d'un système micromécanique masselotte-ressort comprenant une masselotte (23) et un ressort (25), le procédé comprenant les stades dans lesquels :
on se procure un substrat (20) de silicium, le substrat de silicium étant dans le plan [100];
on forme une masselotte (11, 23, 41) sur le substrat;
**caractérisé en ce que** le procédé comprend en outre les stades dans lesquels :
on attaque de manière anisotrope ou isotrope par voie humide ou par RIE sèche le substrat (20) de silicium, suivant un angle souhaité par rapport au plan [100], pour définir une section (2, 6, 14) inclinée sur laquelle le ressort (25) doit être formé;
on forme une couche (3, 8, 15) de surface, ayant une épaisseur déterminant l'épaisseur d'un ressort à former sur la surface du substrat;
on attaque pour former un ressort (4, 16, 9, 25, 41) à partir de la couche de surface; et
on attaque à sec pour détacher la masselotte et le ressort du substrat.

2. Procédé de fabrication d'un système micromécanique masselotte-ressort suivant la revendication 1, dans lequel on attaque de manière anisotrope le substrat de silicium pour définir la section inclinée parallèlement au plan [111].

3. Procédé de fabrication d'un système micromécanique masselotte-ressort suivant la revendication 1 ou 2, le procédé comprenant, en outre, le stade dans lequel :
on dope la surface du substrat par l'intermédiaire d'une implantation d'ion ou d'un dépôt en surface, de manière à produire un dopage opposé, afin de former la couche de surface.

4. Procédé de fabrication d'un système micromécanique masselotte-ressort suivant la revendication 3, le procédé comprenant, en outre, le stade dans lequel :
on effectue un arrêt d'attaque à l'encontre d'une technique de jonction pn pour donner une forme dissymétrique au ressort dissymétrique.

5. Procédé de fabrication d'un système micromécanique masselotte-ressort suivant l'une quelconque des revendications précédentes, dans lequel la couche de surface est en silicium monocristallin.

6. Procédé de fabrication d'un système micromécanique masselotte-ressort suivant l'une quelconque des revendications 1 à 3, comprenant, en outre, le stade dans lequel:
on forme une couche sacrificielle entre le substrat de silicium et la couche de surface par une oxydation thermique.

7. Procédé de fabrication d'un système micromécanique masselotte-ressort suivant l'une quelconque des revendications 1 à 3, comprenant, en outre, le stade dans lequel :
on forme une couche sacrificielle par un, dépôt d'un matériau sur le substrat de silicium.

8. Procédé de fabrication d'un système micromécanique masselotte-ressort suivant la revendication 6 ou 7, dans lequel la couche de surface est en l'un de polysilicium, de SiC, de Ti, de Ni ou de TiNi.

9. Système masselotte-ressort fabriqué par le procédé suivant les revendications précédentes.

10. Accéléromètre à 2 axes ou à 3 axes, comprenant un système masselotte-ressort suivant la revendication 9.

11. Détecteur de vitesse angulaire, comprenant un système masselotte-ressort suivant la revendication 9.

12. Unité de mesure d'inertie (UMI), comprenant un ou plusieurs systèmes masselotte-ressort suivant la revendication 9.

13. Unité de mesure d'inertie (UMI) suivant la revendication 12, l'UMI comprenant une puce, la puce comprenant un gyromètre à 2 axes et un accéléromètre à 3 axes.

14. Unité (UMI) de mesure d'inertie suivant la revendication 13, l'UMI comprenant en outre une deuxième puce ayant des moyens de traitement d'un signal.
